(19) Europäisches Patentamt
European Patent Office
Office européen des brevets

(11) **EP 4 679 125 A1**

(12) **EUROPEAN PATENT APPLICATION**

(43) Date of publication:
**14.01.2026 Bulletin 2026/03**

(21) Application number: **24188261.2**

(22) Date of filing: **12.07.2024**

(51) International Patent Classification (IPC):
**G01R 33/565** (2006.01)     **G01R 33/48** (2006.01)
**G01R 33/561** (2006.01)

(52) Cooperative Patent Classification (CPC):
**G01R 33/56509; G01R 33/482; G01R 33/5611**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Siemens Healthineers AG**
**91301 Forchheim (DE)**

(72) Inventors:
• **Cauley, Stephen Farman**
  **Winchester, 01890 (US)**
• **Clifford, Bryan**
  **Belmont, 02478 (US)**
• **Polak, Daniel**
  **91052 Erlangen (DE)**
• **Splitthoff, Daniel Nicolas**
  **91080 Uttenreuth (DE)**

(74) Representative: **Siemens Healthineers**
**Patent Attorneys**
**Postfach 22 16 34**
**80506 München (DE)**

(54) **A METHOD FOR GENERATING A MOTION-CORRECTED MAGNETIC RESONANCE IMAGE DATASET**

(57)    The invention relates to a method for generating a motion-corrected magnetic resonance image dataset of a body region of a subject, the method comprising (a) receiving magnetic resonance data acquired of the body region (40, 42); (b) optionally receiving information on the body region (40, 42) covered by the magnetic resonance image dataset; (c) weighting at least part (48) of the received magnetic resonance data by reducing the signal originating from parts (42) of the body region which are expected to have undergone non-rigid and/or independent motion during the acquisition, thereby producing weighted magnetic resonance data (46); and (d) estimating the motion-corrected image dataset (x) by minimizing (56) the data consistency error between the magnetic resonance data (14) acquired in the imaging protocol and a forward model described by an encoding matrix, wherein the encoding matrix includes motion parameters ($\theta_i$), Fourier encoding (F), and optionally subsampling (M) and/or coil sensitivities (C) of a multichannel coil array (7.1, 7.2), wherein the estimation includes at least one step of estimating (54) motion parameters ($\theta_i$) from the weighted magnetic resonance data (46).

FIG 5

$$[\hat{\theta}_i] = \mathrm{argmin}_{\theta i} \| E_{\theta i}\hat{\chi} - s_i \|_2^2$$

$$[\hat{\chi}] = \mathrm{argmin}_{\chi} \| E_{\hat{\theta}}\chi - s \|_2^2$$

**Description**

The invention relates to a method for generating a motion-corrected magnetic resonance image dataset, to a computer program and to a magnetic resonance imaging apparatus.

Independent of the grammatical term usage, individuals with male, female or other gender identities are included within the term.

Patient motion is one of the most common and costly artefacts in Magnetic Resonance Imaging (MRI) and can seriously degrade the diagnostic quality of magnetic resonance (MR) exams.

Fast imaging protocols reduce the impact of motion. For example, parallel imaging techniques, as summarised in J. Hamilton, D. Franson, and N. Seiberlich "Recent Advances in Parallel Imaging for MRI," Prog. Nucl. Magn. Reson. Spectrosc., vol. 101, pp. 71-95, 2017, exploit the properties of modern multi-channel coil arrays to separate aliased pixels in the image domain or to estimate missing k-space data, using knowledge of nearby acquired k-space points, in order to allow scan time reduction by sampling a smaller number of phase encoding lines in k-space.

Some retrospective motion correction techniques involve measuring the motion by additional image navigator scans. The desired motion information is obtained by registering the individual navigator images with one another. However, navigator-based approaches are limited to specific sequences/contrasts which provide enough dead time to accommodate for the repeated acquisition of navigators.

By contrast, navigator-free retrospective motion correction techniques attempt to estimate the motion trajectory and motion-free image from the acquired magnetic resonance data itself. By including motion parameters into the MR forward model, these techniques account for the patient's motion in the final image reconstruction and therefore reduce motion artefacts. This can for example be accomplished by minimizing the data consistency error of a parallel "imaging + motion" forward model, as described in L. Cordero-Grande, R. Teixeira, E. Hughes, J. Hutter, A. Price, Hajnal, "Sensitivity Encoding for Aligned Multishot Magnetic Resonance Reconstruction," IEEE Trans. Comput. Imaging, vol. 2, no. 3, pp. 266-280, 2016 and M. W. Haskell, S. F. Cauley, and L. L. Wald, "TArgeted Motion Estimation and Reduction (TAMER): Data consistency based motion mitigation for MRI using a reduced model joint optimization," IEEE Trans. Med. Imaging, vol. 37, no. 5, pp. 1253-1265, 2018. When the "imaging + motion" model and the underlying imaging protocol also include parallel imaging techniques which make use of the complex sensitivity profiles of multi-channel coil arrays, such as SENSE (SENSitivity Encoding) or ASSET (Array coil Spatial Sensitivity Encoding), it is referred to as "SENSE + motion" model.

In the TAMER method, the motion and image vector are jointly estimated via an inversion of the "imaging + motion" forward model. This corresponds to a large-scale non-linear optimization problem that is typically computationally very expensive. Previously proposed methods alternate between optimizing just the image or the motion parameters while assuming the other to be fixed (see L. Cordero-Grande in Magn. Reson. Med.), instead of updating all optimization variables at once. Nevertheless, repeated updates of the imaging voxels lead to long computation times that have so far impeded wide-spread clinical adoption.

In "Scout accelerated motion estimation and reduction (SAMER)", Magn. Reson. Med., vol. 87, pp. 163-178, 2022, https://doi.org/10.1002/mrm.28971, D. Polak, D. N. Splitthoff, B. Clifford, W.-C. Lo, S. Huang, J. Conklin, L. L. Wald, K. Setsompop and S. Cauley propose a technique that utilizes a single rapid scout scan to drastically reduce the computational cost of motion estimation. The scout image contains centre of k-space information which is compared against the k-space data of the actual MR acquisition for each shot, to derive the subject's motion. This corresponds to registration of the k-space data with the scout image in k-space. This strategy is used to completely avoid the alternating optimization of subject motion and image volume, which is otherwise required in retrospective motion correction techniques. In the SAMER-technique, a motion trajectory of the subject is first estimated, and the motion trajectory is then used in a motion-aware parallel image reconstruction, using e.g. a "SENSE + motion" forward model, to yield the motion-mitigated image. This reduces the computational costs by several orders of magnitude, when compared to established alternating optimization methods.

In D. Polak, J. Hossbach, D. N. Splitthoff et al. "Motion guidance lines for robust data consistency-based retrospective motion correction in 2D and 3D MRI", Magn. Reson. Med. 2023:1-14, doi: 10.1002/mrm.29534, D. Polak et al. have extended the SAMER method to include the repeated acquisition of a small number of motion guidance lines in each shot, which are used for motion estimation by being compared with the data from the scout scan. The SAMER extension no longer requires changes to the standard sequence ordering, i.e. one can retain the normal linear acquisition order of e.g. MPRAGE. This allows for very rapid and fully separable estimation of motion parameters shot-by-shot.

In the above cited methods for retrospective motion correction, a rigid-body motion model is often used for motion estimation and artefact correction; however, this rigid-body assumption is often not valid. Rather, the human body has multiple articulations and joints, so that several body parts of the subject may move non-rigidly and/or independently from one another. Neglecting this aspect and treating the entire field-of-view (FOV) as a rigid body can lead to inaccurate motion estimates and therefore motion artefacts in the final image.

It is therefore an object of the present invention to overcome these problems of retrospective motion correction techniques in MRI. In particular, it is an object of the invention to provide a method for providing a motion-corrected MR image having fewer motion artefacts.

These objects are met or exceeded by a method for generating a motion-corrected magnetic resonance image dataset of a body region of a subject, the method comprising:

(a) receiving magnetic resonance data acquired of the body region using a magnetic resonance imaging protocol, in which spatial encoding is performed using phase encoding gradients along at least one phase encoding direction, and frequency encoding gradients along a readout direction, wherein k-space is sampled during the imaging protocol in a plurality of k-space lines oriented along the readout direction, and having different k-space positions in the at least one phase encoding direction;

(b) optionally receiving information on the body region covered by the magnetic resonance image dataset;

(c) weighting at least part of the received magnetic resonance data by reducing the signal originating from parts of the body region which are expected to have undergone non-rigid and/or independent motion during the acquisition, thereby producing weighted magnetic resonance data; and

(d) estimating the motion-corrected image dataset by minimizing the data consistency error between the magnetic resonance data acquired in the imaging protocol and a forward model described by an encoding matrix, wherein the encoding matrix includes motion parameters, Fourier encoding, and optionally subsampling and/or coil sensitivities of a multi-channel coil array, wherein the estimation includes at least one step of estimating motion parameters from the weighted magnetic resonance data.

The invention is based on the insight that, although the rigid-body assumption may not be correct for the entire field-of-view (FOV), it often is a good approximation for a part of the FOV. Another part of the FOV may include body parts that do not move rigidly, or which move rigidly but independently from the part for which the rigid-body assumption holds. For example, in head imaging, the skull/brain typically moves rigidly, while the mouth/jaw/neck area may move non-rigidly and/or independently from the skull/brain area. In such instances, the retrospective motion correction may profit, if the estimation of the motion parameters is performed only on data acquired from a body part which does move rigidly - in this example, the skull/brain portion of the image. Preferably, the estimation of the motion parameters is done on the body part which is of most diagnostic importance. In the case of head imaging, this usually is the skull/brain, whereas the mouth/jaw/neck just happen to be within the FOV. Thus, the signal originating from body parts which are expected to move non-rigidly and/or independently from the body part which is of most interest, should be reduced when estimating motion parameters

This is done according to the invention by weighting at least part of the received magnetic resonance data by reducing the signal originating from parts of the body region which are expected to have undergone non-rigid and/or independent motion during the acquisition, thereby producing weighted magnetic resonance data; and estimating motion parameters from the weighted magnetic resonance data. The step of estimating motion parameters is usually done in the course of the image reconstruction including retrospective motion correction. Within the image reconstruction, preferably estimating motion parameters and calculation of the motion-corrected image are two separate steps. The image reconstruction may be performed by any data-driven retrospective motion correction technique, in particular by one of the techniques cited above (SAMER, TAMER etc.).

Thereby, the stability and robustness of retrospective motion correction is improved by removing/reducing non-rigid signal sources from the motion estimation. This is achieved by removing or at least down-weighting signal originating from non-rigid and/or independently moving areas in the imaging FOV. The invention may also benefit other clinical applications in which motion correction has so far not been successful by retrospective motion correction, for example MR imaging of body parts which are subject to hard-to-correct motion types, e.g., liver, prostate, etc.

The imaging protocol used in the acquisition of the magnetic resonance data may be based on any type of imaging sequence, for example a spin-echo, turbo spin-echo, or gradient echo sequence. It may have T1-weighted, T2-weighted or other contrast. It may be a steady state sequence such as FLASH, or a non-steady-state sequence, i. e. one in which the signal intensity or contrast varies over an echo train in particular due to T1 and/or T2 relaxation, such as MPRAGE (Magnetization Prepared Rapid Gradient Echo Imaging) or TSE. A further example of the imaging protocol is a SPACE sequence (Sampling Perfection with Application optimized Contrast using different flip angle Evolution), but other types of imaging sequences are also possible.

The thereby acquired magnetic resonance image dataset, also referred to as "image dataset" or "image", may be a three-dimensional (3D) image dataset or a two-dimensional (2D) image dataset. A 3D image dataset is acquired using two phase encoding directions, wherein a 2D image dataset comprises one or preferably a stack of 2D slices. A 2D image dataset is acquired using a slice selection gradient typically followed by phase encoding in one in-plane direction and frequency encoding in the other in-plane direction. The image dataset is typically acquired for diagnostic purposes and thus preferably has a high spatial resolution of, for example, an in-plane resolution of 0.3mm - 3mm, preferably 0.4-2mm. The voxel size may be for example e.g. 0,5 to 12mm$^3$, preferably 2 to 8mm$^3$. For a 2D image, the in-plane resolution may for example be 0.3mm - 2mm, preferably 0.4-1.2mm.

The inventive method may be executed on magnetic resonance data acquired by any medical or other MRI apparatus, also referred to as MR scanner herein. The subject may be human or animal, in particular a patient to be examined. The image dataset is in particular acquired from a body part that is subject to undesired motion, for example the head/neck are, a limb such as a leg, arm, knee, hand, or a part subjected to breathing motion such as the thorax or abdomen.

The method of the invention can optionally include a step of receiving information on the body region covered by the magnetic resonance image dataset. In case this information is not given, it can be determined automatically. From the information on the body region, the method of the invention can derive which part of the magnetic resonance data needs to be reduced, in order to suppress non-rigid signal sources. The method of the invention may rely on prior knowledge on how the different parts of the body are expected to move. For example, the head moves rigidly, whereas the jaw and neck area may move non-rigidly. The information on the body region may be obtained from various sources. For example, it may be derived from prior knowledge about the image to be acquired, for example from the diagnostic question. For example, if the patient is scheduled for a head scan, the MRI apparatus already knows that the body region will be the head and neck. It will also know the orientation of the patient to be head-first within the sensitive volume of the MR scanner, i.e. the neck is in the lower part of the FOV and the head in the upper part of the FOV. In other embodiments, the information of the body region may be derived from an MR image, for example a low-resolution image acquired previously from the body region. Alternatively, the information of the body region may be derived from the magnetic resonance data acquired in the imaging protocol (possibly before it is motion-corrected.

According to an embodiment, the parts of the body region which are expected to have undergone non-rigid motion during the acquisition, are determined from a magnetic resonance image of the body region, in particular from a low-resolution image. Such low-resolution image may be processed by an algorithm which is programmed or trained to recognize the depicted anatomy. The algorithm may be an artificial intelligence algorithm, in particular a deep learning algorithm.

"Reducing" the signal originating from parts of the body region which are expected to have undergone non-rigid and/or independent motion, may mean a full suppression of the relevant signal, i.e. setting it to 0. It may also mean a partial reduction, wherein the signal amplitude is reduced for example to less than 60%, preferably less than 50%, more preferred less than 30% of its original (as acquired) value. The "reducing" may also include a weighting using a function, for example a pre-determined function. Examples will be described herein below.

The magnetic resonance data acquired from the body region during the imaging protocol is designed to be reconstructed using data-driven retrospective motion correction techniques, such as TAMER, SAMER, or the technique disclosed by D. Polak et al. in Magn. Reson. Med. 2023:1-14.

The motion parameters are preferably rigid-body motion parameters, wherein one motion state is described by three translational and three rotational parameters. In some embodiments, they may also be non-rigid motion parameters, such as affine motion parameters. Affine motion parameters include 12 parameters for each motion state and describe also states of compression and torsion. The estimated motion parameters preferably comprise a motion trajectory, i.e. a sequence of motion states of the body region during the acquisition of the imaging protocol. The motion trajectory may be estimated from sets of motion guidance lines acquired throughout the imaging sequence and a low-resolution scout image, according to the technique disclosed by D. Polak et al. in Magn. Reson. Med. 2023:1-14.

According to an embodiment, the estimation includes at least one first step of estimating motion parameters from the weighted magnetic resonance data, while using a fixed estimate for the image dataset, and at least one second step of estimating the motion-corrected image dataset by minimizing the data consistency error between the magnetic resonance data acquired in the imaging protocol and the forward model described by an encoding matrix, wherein the encoding matrix includes the motion parameters estimated in the first step. For example, the algorithm may alternate between optimizing just the image or the motion parameters while assuming the other to be fixed (see L. Cordero-Grande in Magn. Reson. Med.), instead of updating all optimization variables at once. In other embodiments, a SAMER method is used, wherein the motion parameters, in particular a motion trajectory, is estimated once, using the scout image, and the motion parameters are then used in a motion-aware parallel image reconstruction, using e.g. a "SENSE + motion" forward model, to yield the motion-mitigated image. This embodiment is advantageous because the motion parameters are estimated from the weighted magnetic resonance data, in which signal contributions from non-rigidly moving regions are reduced, and thus the motion parameters will be more accurate.

According to an embodiment, the step of weighting at least part of the received magnetic resonance data includes weighting the voxel data of at least some k-space lines depending on a voxel location in readout direction, in particular by supressing the voxel data originating from readout locations above or below a threshold location. This method is referred to herein as "*readout segmentation*". It is particularly effective when used in combination with the SAMER method, because SAMER relies on the motion parameters being derived from of a small number of additional k-space lines, also referred to as guidance lines. In this case, the weighting is done on the guidance lines, i.e. the "at least some k-space lines" are the guidance lines. A set of guidance lines comprises a few (e.g. 2 to 16, preferably 4-8) k-space lines (fully sampled in readout direction) and therefore does not provide enough spatial image information to allow a segmentation of the image in all three spatial directions. However, in readout direction (x), the resolution may be high without any time penalty, and therefore it is possible to segment the guidance lines in readout direction. This segmentation, followed by weighting or suppression, is preferably done in the image domain, not in k-space domain. For the further processing, the weighted MR data may be transformed back into k-space notation Therefore, it is possible to weigh the guidance line data by reducing the contribution from parts of the body region which should not contribute to the estimation of the motion trajectory in one spatial direction. For example, one may "cut off" a part of the image in readout direction, so that this part of the image does not contribute to the motion estimation. For example, the neck portion may be cut off. When imaging e.g. the liver, an image portion including intestines may be suppressed. According to an embodiment, the imaging protocol is adapted such that the readout direction is oriented such that those portions of the body part which move non-rigidly and/or independently are on one side of the FOV in readout direction, so that they can be effectively segmented.

In this embodiment, the influence of non-rigid signal sources (e.g., neck/mouth) may be reduced by restricting the SAMER motion optimization to readout (x) voxel locations that primarily exhibit rigid-body motion (e.g., the skull/brain in head imaging).

The weighting may include a complete data suppression or exclusion, i.e. setting the signal to 0. More generally, the weighting may include a weighting using a function of the readout voxel location. The function may have a threshold location, wherein the voxels on one side of the threshold (= above/below the threshold) are set to 0, whereas the voxels on the other side of the threshold are retained. The function may also have a smoother transition at a threshold location, e.g. a tanh function. In an embodiment, about 40-85%, preferably 55-75%, of the readout voxels are chosen for motion estimation, while the rest is suppressed (set to 0), i.e. discarded for the purposes of motion estimation.

According to an embodiment, the voxel data originating from readout locations above or below a threshold location are reduced, in particular suppressed. This threshold may be determined specially for every subject and imaging protocol, e.g., based on a low-resolution MR image, such as a pre-scan. Such MR image may be processed by an algorithm to determine a suitable threshold location in readout direction.

According to an embodiment, the threshold location is determined from a centre of mass of a magnetic resonance image of the body region. The MR image may for example by a low resolution scout image, for example a pre-scan.

Thus, a suitable reference point for such a thresholding approach is to use the centre of mass of a projection image, wherein the projection is in the phase-encode directions, and the centre of mass along the readout direction on the projection image is determined. The centre of mass may be determined from the guidance lines, or from other magnetic resonance data acquired from the body region, for example from a low-resolution MR image. The threshold may be set at a pre-determined distance above or below the centre of mass. It may be set at a pre-determined percentage of the FOV above or below the centre of mass. There may be several thresholds, for example one in the upper part of the FOV and one in the lower part of the FOV, wherein the voxel data above the upper threshold and the voxel data below the lower threshold are suppressed. Thus, parts of the image at both ends of the FOV in readout direction may by "cut off" for the purposes of motion estimation. The position of each threshold location may be determined independently, Thus, the amount of readout cropping (thresholding) may vary between the upper and lower FOV boundary.

According to an embodiment, the body region is the head of the subject and the readout direction is oriented along the top-bottom direction of the subject, and wherein the step of weighting at least part of the received magnetic resonance data includes suppressing the voxel data originating from readout locations covering the neck and/or mouth of the subject. Thereby, the motion trajectory from the rigidly moving skull/brain area may be accurately determined, by excluding the non-rigid jaw, neck and mouth. This is acceptable because a head scan is usually done in order to examine the brain, which is within the skull area.

According to an embodiment, the magnetic resonance data is acquired using a multi-channel coil array, and wherein the step of weighting at least part of the received magnetic resonance data includes mixing the receive channels of the multi-channel coil array so as to minimize signal contributions from those parts of the body region which are expected to have undergone non-rigid motion during the acquisition. This approach is also referred to as "*optimized mixing of receive channels*". The coil sensitivity profile of modern multi-channel coil arrays provides additional spatial encoding information which can be leveraged to suppress confounding signal sources, as generally described in L. W. S. Cauley, D. Polak, et al., "Geometric Coil Mixing (GCM) to Dampen Confounding Signals in MRI Reconstruction," Int. Soc. Magn. Reson. Med. Montr., vol. 0449, 2019. This concept may be applied to scout and/or guidance line-based motion estimation, by determining an optimized mixing of the receive channels that minimizes signal from undesired body regions, in particular the parts of the body region which are expected to have undergone non-rigid and/or independent body motion (e.g., mouth/neck). The mixing may be performed by applying a channel mixing matrix. In an embodiment, the channel mixing matrix may simply remove/turn off coil channels which are particularly sensitive to undesired regions of the FOV. In other embodiments, the channel mixing matrix may comprise more general weighting of the receive channels. The mixing matrix may again be computed based on a low-resolution scout image or pre-scan. Also by this method, the motion parameters may be determined more accurately and with less contribution from non-rigid parts of the body region.

In a preferred embodiment, readout segmentation and optimized mixing of receive channels are both used. The combined effect of readout segmentation and optimized mixing of receive channels is particularly advantageous, since it allows good localization and suppression of non-rigid signal sources and can substantially improve SAMER motion mitigation.

According to an embodiment, the weighting step is performed multiple times, each time to reduce the signal originating from different parts of the body region, wherein the different parts are expected to have undergone different motion during the acquisition, and wherein the step of estimating the motion-corrected image dataset includes estimating different motion parameters for the different parts of the body region. Thereby, different, independent motion trajectories may be determined for multiple target regions. For example, in head imaging, one can estimate separate motion trajectories for the brain and the neck/mouth. Similarly, the spine can be divided into multiple sections. This breaks up the complex non-rigid spine motion into a simpler motion model. The individual motion trajectories preferably comprise rigid-motion parameters. They may also comprise non-rigid motion parameters, in particular affine motion parameters (including stretching and compressing motion). However, while it may be desirable to use a higher order motion model (e.g., affine transformation having 12 degrees of freedom), it may be preferably in many instances to use a sufficiently low-dimensional model to provide the best trade-off between accuracy and robustness of the motion estimation/correction. Therefore, rigid-body motion parameters are preferred in many embodiments. According to an embodiment, either or both of readout segmentation and optimized mixing of receive channels are repeated to perform motion estimation/correction for multiple target regions.

The different motion trajectories for the different parts of the body region may be used in various ways. According to a first embodiment, the different motion parameters for the different parts of the body region are used to produce a combined motion field for the complete body region, using boundary conditions in the transitional zones, wherein the combined motion field is used in the estimation of the motion corrected image dataset. The boundary conditions may ensure a smooth transition in motion parameters between the different parts of the body region, which simulates the behaviour of the body, and which is useful in obtaining a smooth reconstructed image, without "fault lines" between the different parts of the body region.

According to a second embodiment, the step (d) of estimating the motion-corrected image dataset includes estimating motion corrected part-images of the different parts of the body region, wherein each part-image is based on different motion parameters, followed by a step of combing the part-images to a complete motion corrected image. Thus, in this embodiment, the different motion trajectories for the different parts of the body region are used to reconstruct separate image parts, referred to as part-images, each part-image corresponding to an independently moving part of the body. These several part-images have to be "stitched together" in order to yield a smooth image, because otherwise there would be visible "fault lines" between the different part-images. The combination may be done by a registration step. For example, the part-images may be deliberately reconstructed so that they overlap one another, and the overlap regions may be registered with one another. Thereby, a complete motion-corrected image may be reconstructed, wherein different parts of the image have undergone different motion trajectories.

According to an embodiment, the weighting step is performed on sets of additional k-space lines acquired within a central region of k-space during the magnetic resonance imaging protocol. The sets of additional k-space lines are used for motion estimation, in particular to detect movement of the object throughout the imaging sequence, because for this purpose it is useful to have the central area of k-space sampled at regular intervals. This is disclosed e.g. D. Polak et al. in Magn. Reson. Med. 2023:1-14. "Additional" means that the k-space lines are acquired in addition to those that are required under the imaging protocol to acquire the MR image, i.e. they are redundant when it comes to image reconstruction. The sets of additional k-space lines are typically at the same position in k-space at each acquisition, but this is not mandatory.

In useful embodiments, a set of guidance lines is acquired once or a few times in every echo train. An "echo train", also referred to as "shot", comprises a plurality of MR echoes, e.g. spin echoes and/or gradient echoes. During each echo, a k-space line is acquired. An echo train may be acquired after a single preparation pulse, such as an inversion pulse. In most sequences, an echo train comprises a preparation pulse, and then all echoes have their own excitation/refocussing pulses, except in echo-planar imaging. The guidance lines preferably provide sufficient spectral information to perform accurate motion estimation and retrospective motion correction. By weighting the guidance lines as proposed by the present invention, the motion estimation is improved.

According to an embodiment, the magnetic resonance data has been acquired using a method comprising acquiring a low-resolution scout image dataset of the body region, and acquiring sets of additional k-space lines within a central region of k-space at - at least approximately - regular intervals during the imaging protocol. The low-resolution scout image preferably covers the same field-of-view as the magnetic resonance image dataset. Thus, in case of a 3D imaging, it covers the same volume. In case the image dataset is a stack of 2D slices, the scout image comprises also a stack of low-resolution 2D slices. However, it is possible that the low-resolution scout comprises fewer slices than the high-resolution image, for example only every second or third slice. The low-resolution scout image may have a spatial resolution of 2-8mm, preferably 3-5mm, for example 4mm, in the phase-encoding direction(s).

Preferably, the acquisition of the scout is very rapid, requiring e.g. 1-5 sec, preferably 1-2 secs. It is preferably acquired once before or after the imaging protocol, preferably before.

According to an embodiment, the method comprises receiving a low-resolution scout image dataset of the body region, and receiving sets of additional k-space lines within a central region of k-space at - at least approximately - regular intervals during the imaging protocol, weighting the sets of additional k-space lines by reducing the signal depending on a voxel location in readout direction, so as to produce weighted additional k-space lines; estimating the motion-corrected image dataset by minimizing the data consistency error between the magnetic resonance data acquired in the imaging protocol and the forward model, wherein the estimation includes:

in a first step, estimating motion parameters for each set of weighted additional k-space lines by minimizing the data consistency error between the weighted additional k-space lines and the forward model using the low-resolution scout scan as an estimate for the image dataset; and in a second step, estimating the motion-corrected image dataset by minimizing the data consistency error between the magnetic resonance data acquired in the imaging protocol and a forward model described by an encoding matrix, wherein the encoding matrix includes the motion parameters estimated in the first step for each set of weighted additional k-space lines, Fourier encoding, and optionally subsampling and/or coil sensitivities of a multi-channel coil array.

The sets of additional k-space lines are acquired in a central region of k-space, wherein the central region is preferably covered by the low-resolution scout image. However, each set of additional k-space lines typically comprises fewer k-space lines than would be required to reconstruct a scout image. For example, a set of k-space lines may comprise 1 to 8, preferably 1-4, k-space lines for each 2D slice of a 2D image dataset. In case the image dataset is a 3D image dataset, a set of k-space lines may comprise 2 to 32, preferably 3-8, k-space lines. The set of additional k-space lines is acquired repeatedly during the imaging protocol, namely at - at least approximately - regular intervals. "At least approximately", when used in this application, may mean within $\pm 15\%$, preferably within $\pm 10\%$, most preferred within $\pm 5\%$. Each set of additional k-space lines is intended to provide information on the position of the subject at the point in time at which the set was acquired. Therefore, the intervals in which the sets are acquired are preferably set to a time which gives a sufficiently high temporal resolution on the one hand, and on the other hand does not take up too much of the total scan time. The interval at which the sets of additional k-space lines are acquired is preferably between 100ms and 3000ms, more preferred between 5000ms and 1500ms. In 3D imaging protocols, typically one set of guidance lines is acquired per TR, e.g., every 1-3 seconds. In 2D imaging protocols, guidance lines are preferably acquired in every slice, e.g. every 80-250 ms, however, to estimate one motion state, guidance line information from multiple slices needs to combined to obtain through-plane information. Hence, the temporal resolution in 2D may also be in the 1-2sec range.

The estimation is preferably carried out in two steps: in a first step, motion parameters are estimated for each set of guidance lines by minimizing the data consistency error of the forward model, which may amount to a comparison with the low-resolution scout image. In a second step, the motion-corrected image is estimated using the motion parameters estimated in the first step. Thereby, alternating between repeated updates of the otherwise coupled optimisation variables x (image vector) and θ (motion parameters) is avoided. Rather, the rapid scout image dataset is used as an image estimate $\tilde{x}$. This leads to a highly efficient optimisation problem that is fully separable across the echo trains and does not require repeated updates of x, which may comprise millions of imaging voxels. The minimisation problem may be derived from a SENSE parallel imaging forward model, as described in K. P. Pruessmann, M. Weiger, M. B. Scheidegger, and P. Boesiger, "SENSE: sensitivity encoding for fast MRI," Magn. Reson. Med., vol. 42, no. 5, pp. 952-962, 1999, with rigid body motion parameters included ("SENSE + motion"). The overall method is described in Magn. Reson. Med. 2023:1-14, doi: 10.1002 / mrm.29534, which is incorporated herein by reference.

According to a further aspect of the invention, a computer configured to generate a motion-corrected magnetic resonance image dataset is provided. The computer may be any computer comprising a sufficiently powerful processing unit, which may be a CPU or GPU, or several such processing units. Accordingly, the computer may be a PC, a server, a console of an MRI apparatus, but it also may be a computer that is remote from the MRI apparatus, it may be connected with it through the internet. Accordingly, the computer may also be a cloud computer, a remote server etc. The computer may also be a mobile device, such as a laptop, tablet computer or mobile phone.

According to a further aspect of the invention, a computer program is provided which includes program code, which causes a computer - such as the computer described herein - to execute the inventive method, in particular to carry out an algorithm the method for generating a motion-corrected magnetic resonance image dataset.

According to a further aspect, the invention is directed to a non-transitory computer-readable medium containing a computer program as described herein. The computer-readable medium may be any digital storage medium, such as a hard disc, a cloud, an optical medium such as a CD or DVD, a memory card such as a compact flash, memory stick, a USB-stick, multimedia stick, secure digital memory card (SD) etc.

In a further aspect of the invention, a magnetic resonance imaging apparatus is provided which comprises a radio frequency controller configured to drive an RF-coil, preferably comprising a multi-channel coil-array, a gradient controller configured to control gradient coils, and a control unit configured to control the radio frequency controller and the gradient controller to execute the imaging protocol according to the invention. The MRI apparatus further comprises a processing unit configured to execute the method described herein. The MRI-apparatus may be a commercially available MRI-apparatus which has been programmed to perform the method of the invention.

All features and advantages disclosed with regard to the method for generating a motion-corrected MRI dataset may be embodied in the MRI apparatus, computer program and computer-readable storage medium according to other aspects of the invention and vice versa.

The accompanying drawings illustrate various example embodiments of various aspects of the invention. In the drawings:

Fig. 1 is a schematic representation of an MRI apparatus according to an embodiment of the invention;

Fig. 2 is a schematic representation of a three-dimensional k-space;

Fig. 3 is a sequence diagram of an MRRAGE sequence with motion guidance lines;

Fig. 4 is an illustration of an alternating optimization algorithm;

Fig. 5 is an illustration of a SAMER optimization;

Fig. 6 is a sagittal MR image through the head;

Fig. 7 is a segmentation of the brain from the sagittal image of Fig. 6; and

Fig. 8 illustrates the content of a set of guidance lines in image space.

Similar elements are designated with the same reference signs in the drawings.

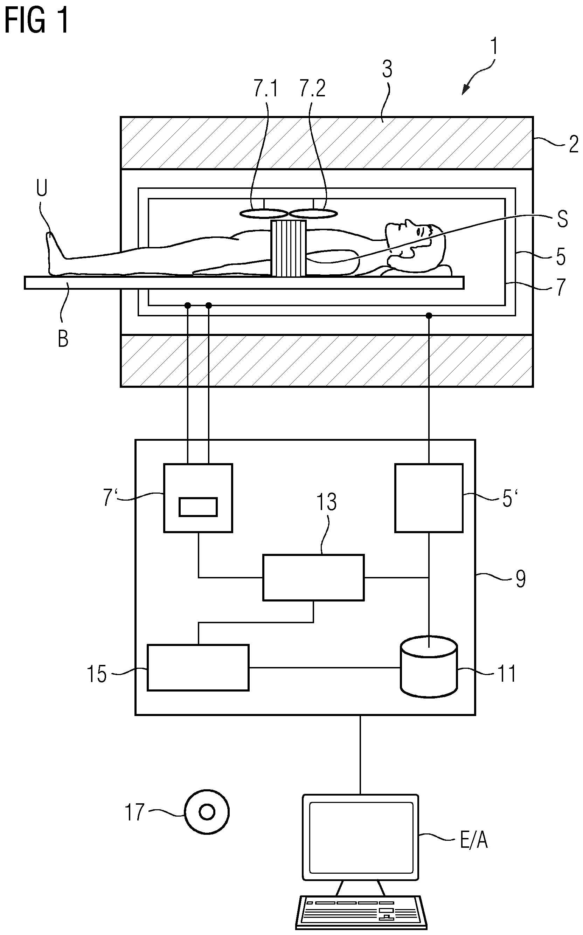

Fig. 1 schematically shows an inventive magnetic resonance (MR) apparatus 1. The MR apparatus 1 has an MR data acquisition scanner 2 with a magnet 3 that generates the constant magnetic field, a gradient coil arrangement 5 that generates the gradient fields, one or several radiofrequency (RF) antennas 7 for radiating and receiving RF signals, and a control computer 9 configured to perform the inventive method. The radio-frequency antennas 7 may include a multi-channel coil array comprising at least two coils, for example the schematically shown coils 7.1 and 7.2, which may be configured to transmit and/or receive RF signals (MR signals).

In order to acquire MR data from an examination subject U, for example a patient or a phantom, the subject U is introduced on a bed B into the measurement volume of the scanner 2. MR data can be acquired using a method according to an embodiment of the invention from a stack S of 2D slices. The control computer 9 controls the MR apparatus 1, and the gradient coil arrangement 5 with a gradient controller 5' and the RF antenna 7 with a RF transmit/receive controller 7'. The RF antenna 7 has multiple channels corresponding to the multiple coils 7.1, 7.2 of the coil arrays, in which signals can be transmitted or received. A control unit 13 of the control computer 9 is configured to execute all the controls and computation operations required for acquisitions. The control computer 9 also has a processing unit 15 for performing the method of the invention. Intermediate results and final results required for this purpose or determined in the process can be stored in a memory 11 of the control computer 9. A user can enter control commands and/or view displayed results, for example image data, an input/output interface E/A. A non-transitory data storage medium 17 can be loaded into the control computer 9 and may be encoded with programming instructions (program code) that cause the control computer 9, and the various functional units thereof described above, to implement any or all embodiments of the method according to the invention.

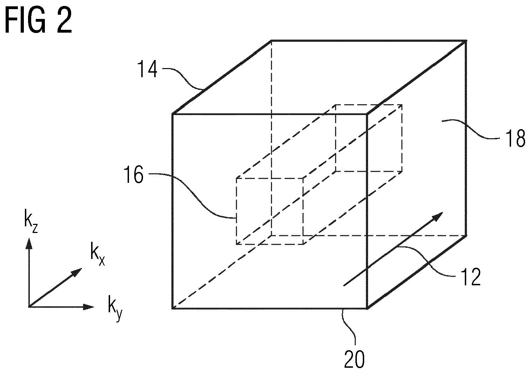

Fig. 2 illustrates a three-dimensional k-space 14 having dimension $k_x$ in frequency encoding (readout) direction, and $k_y$ and $k_z$ in the phase encode plane 20. A k-space line acquired during one echo is illustrated at 12. The k-space volume 14 includes a central region 16 and a periphery 18. The additional k-space lines as well as the k-space lines acquired for the low-resolution scout are located in the central region 16. In the phase encode plane 20, the central region 16 may cover about 1/12 to 1/16 in each direction, i.e. less than 1/100 of the total square phase encode plane 20.

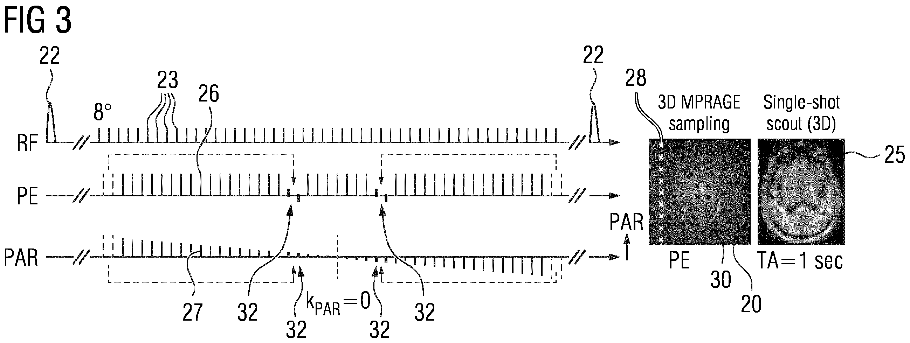

Fig. 3 illustrates a 3D MPRAGE sequence with motion guidance lines according to the prior art disclosed in Magn. Reson. Med 2023:1-14, doi: 10.1002/mrm.29534. On the left, a sequence diagram is shown indicating the RF pulses on the top, the phase encode (PE) gradients in the first direction in the middle, and the phase encode gradients in the second direction (PAR for partition) at the bottom. As usual for MPRAGE, an echo train starts with a 180° inversion pulse 22, followed by a wait time and then by a series of low flip angle (here 8°) pulses 23, wherein a k-space line is acquired after each pulse 23. The ordering is linear, wherein after each readout, phase encode gradient blips 26, 27 are applied in the PE and PAR directions, so that the phase encode plane 20 is sampled in a straight line, as illustrated at 28, wherein each point 28 indicates a k-space line oriented perpendicular to the phase encode plane 20. Four echoes from the regular imaging protocol were removed from the echo train to accommodate four guidance lines 30 located near the centre of k-space. Alternatively, the guidance lines 30 are acquired in addition to the normal imaging data, i.e. the echo train is made slightly longer. The respective phase encode gradients are illustrated at 32. The echo train may have e.g. 150 to 240 echoes. It may be e.g. 0,5 s to 1,5 s long. The corresponding 3D MPRAGE low-resolution scout image 25 may be acquired in a single shot, which requires only an acquisition time TA of about 1 sec.

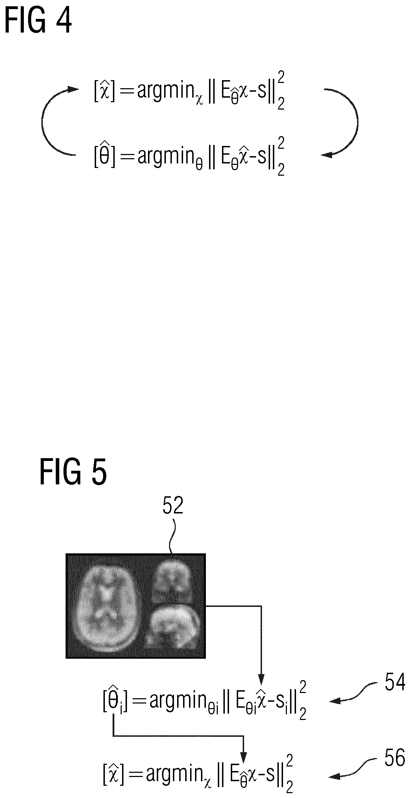

A retrospective motion correction technique which may be used to estimate the motion states, will now be described with reference to Fig. 4 and 5. The mathematical model used is an extension of SENSE parallel imaging, as described in the above-cited paper by K. P. Pruessmann et al., with rigid-body motion parameters included into the forward model. The forward model or encoding operator $E_\theta$ for a given patient motion vector $\theta$ (comprising motion parameters over time, in particular a motion trajectory) relates the motion-free image x to the acquired multi-channel k-space data s. At each time point i that is considered, e.g. the acquisition time of the sets of guidance lines, the subject's position is described by a new set of six rigid-body motion parameters $\theta_i$ that describe the 3D position of the object. Accordingly, the multi-channel k-space data $s_i$ acquired at time point $i$ may be related to the 3D image volume x through image rotations $R_i$, image translations $T_i$, coil sensitivity maps C, Fourier operator F and under-sampling mask $M_i$ by the following formula 1

$$s_i = E_{\theta_i} x = M_i \, F \, C \, T_{\theta_i} R_{\theta_i} x \qquad [1]$$

In some retrospective motion correction methods, as illustrated in Fig. 4, both the motion corrected image vector x and the motion trajectory $\theta$ are estimated by performing an alternating, repeated optimization between the image vector (formula 2) and the motion vector (formula 3):

$$[\hat{x}] = \text{argmin}_x \left\| E_{\hat{\theta}} x - s \right\|_2 \qquad [2]$$

$$[\hat{\theta}] = \text{argmin}_\theta \left\| E_\theta \hat{x} - s \right\|_2 \qquad [3]$$

In the second step, the weighted magnetic resonance data should be used. This method is possible but computationally demanding as repeated updates of $x$ (millions of imaging voxels) are needed.

Using one or several ultra-fast low-resolution scout scans 52, the motion trajectory may be directly estimated, as illustrated in Fig. 5, thus avoiding the time-consuming alternate optimization. The scout image 52, designated by $\tilde{x}$, approximates the motion-free image volume $\hat{x}$ and each motion state can be determined independently by minimizing the data consistency error of the forward model 54:

$$[\hat{\theta}_i] = \text{argmin}_{\theta_i} \left\| E_{\theta_i} \tilde{x} - s_i \right\|_2 \qquad [4]$$

According to the invention, the weighted magnetic resonance data is used in this step 54. Preferably, the weighted magnetic resonance data comprises guidance lines. Thus, the additional k-space lines are used in this first step of the optimization. Preferably, only the guidance lines are used.

For the final image reconstruction, the motion parameters $\theta_i$ from each set of guidance lines are combined and the motion-mitigated image is obtained from solving a standard least-squares problem 56:

$$[\hat{x}] = \text{argmin}_x \left\| E_{\hat{\theta}} x - s \right\|_2 \qquad [5]$$

This strategy completely avoids the difficult non-linear and non-convex joint optimization that contains millions of unknowns, as it preferably only considers six rigid body parameters per motion optimization, and it does not require computationally costly full or partial updates to the image.

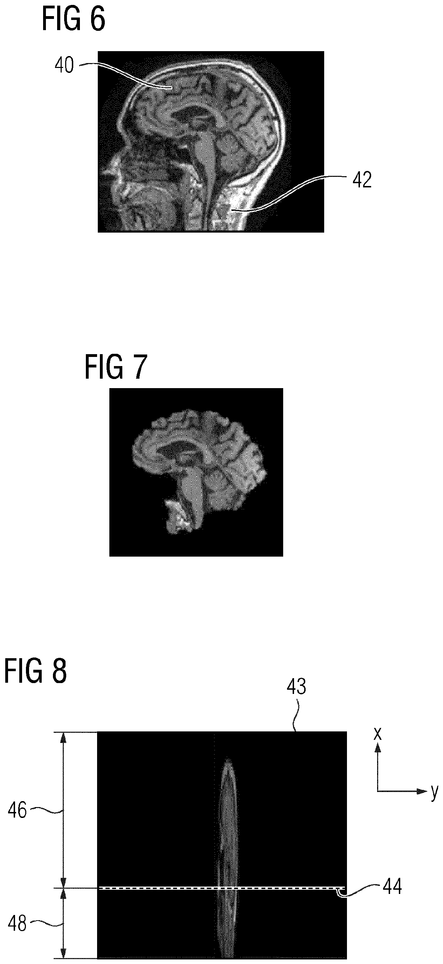

Fig. 6 illustrates a rigidly moving body part 40, in this case the skull, as visible on a sagittal MR image through the head. The neck area 42, by contrast, may move non-rigidly and/or independently from the skull portion.

Fig. 7 depicts a segmentation of the brain from the sagittal image of Fig. 6. Full image navigator approaches would allow brain segmentation, as shown in Fig. 6, in order to remove non-rigid signal sources. However, this is not feasible in SAMER, where the motion information is obtained from a small number of motion guidance lines.

Fig. 8 illustrates the concept of readout segmentation on guidance line data. The image illustrates the content of a few guidance lines, in image space, of the head depicted in Fig. 6. As can be seen the image is essentially a projection along y/z direction, but having full resolution in readout (x) direction. Even in this projection-type image, a threshold position in the readout direction, depicted at 44, can be determined, wherein the threshold separates the region 46 containing the data used for motion estimation, from the region 48, containing data of non-rigidly moving body parts. The data from area 48 is weighted down, or preferably completely discarded in the motion estimation. Thereby, the SAMER motion optimization is restricted to specific readout (x) locations to remove/reduce non-rigid mouth/neck signal.

The invention improves the stability and robustness, especially of scout and guidance lines-based retrospective motion correction by removing/reducing non-rigid signal sources from the SAMER motion optimization. This is achieved by i) masking/re-weighting guidance line data along the readout direction and/or ii) determining an optimized receive channel mixing that removes/downweighs non-rigid areas in the imaging FOV. Both methods can be synergistically combined to achieve good localization/suppression of non-rigid signal. Moreover, the methods of this invention can be used in a multi-target approach to break up complicated non-rigid motion into simpler approximately rigid or affine motion. Knowing the motion of different target regions can be useful in a joint image reconstruction, which considers region-specific motion (e.g., head vs. neck; spine). Moreover, this approach may also benefit other clinical applications, e.g., monitoring of certain hard-to-correct motion types, e.g., liver, prostate, etc.

**Claims**

1. A method for generating a motion-corrected magnetic resonance image dataset of a body region of a subject, comprising:

   (a) receiving magnetic resonance data acquired of the body region (40, 42) using a magnetic resonance imaging protocol, in which spatial encoding is performed using phase encoding gradients along at least one phase encoding direction (PE, PAR), and frequency encoding gradients along a readout direction ($k_x$), wherein k-space (14) is sampled during the imaging protocol in a plurality of k-space lines (12) oriented along the readout direction, and having different k-space positions in the at least one phase encoding direction ($k_y$);
   (b) optionally receiving information on the body region (40, 42) covered by the magnetic resonance image dataset;
   (c) weighting at least part (48) of the received magnetic resonance data by reducing the signal originating from parts (42) of the body region which are expected to have undergone non-rigid and/or independent motion during the acquisition, thereby producing weighted magnetic resonance data (46); and
   (d) estimating the motion-corrected image dataset (x) by minimizing (56) the data consistency error between the magnetic resonance data (14) acquired in the imaging protocol and a forward model described by an encoding matrix, wherein the encoding matrix includes motion parameters ($\theta_i$), Fourier encoding (F), and optionally subsampling (M) and/or coil sensitivities (C) of a multi-channel coil array (7.1, 7.2), wherein the estimation includes at least one step of estimating (54) motion parameters ($\theta_i$) from the weighted magnetic resonance data (46).

2. The method of claim 1,

   wherein the estimation includes at least one first step (54) of estimating motion parameters ($\theta_i$) from the weighted magnetic resonance data, in particular from weighted sets of additional k-space lines (30) acquired within a central region (16) of k-space, while using a fixed estimate for the image dataset,
   and at least one second step (56) of estimating the motion-corrected image dataset by minimizing the data consistency error between the magnetic resonance data (14) acquired in the imaging protocol and the forward model described by an encoding matrix, wherein the encoding matrix includes the motion parameters ($\theta_i$) estimated in the first step.

3. The method of claim 1 or 2, wherein the step of weighting at least part of the received magnetic resonance data includes weighting the voxel data (43) of at least some k-space lines depending on a voxel location in readout direction, in particular by supressing the voxel data originating from readout locations (48) above or below a threshold location (44).

4. The method of any one of the preceding claims, wherein the magnetic resonance data is acquired using a multi-channel coil array (7.1, 7.2), and wherein the step of weighting at least part of the received magnetic resonance data (46) includes mixing the receive channels of the multi-channel coil array (7.1, 7.2) so as to minimize signal contributions from those parts of the body region (42) which are expected to have undergone non-rigid and/or independent motion during the acquisition.

5. The method of any one of the preceding claims, wherein the parts of the body region (42) which are expected to have undergone non-rigid and/or independent motion during the acquisition are determined from a magnetic resonance image (52) of the body region, in particular from a low-resolution image.

6. The method of any one of claims 2 to 5, wherein the threshold location (44) is determined from a centre of mass of a magnetic resonance image of the body region.

7. The method of any one of claims 2 to 6, wherein the body region (40, 42) is the head of the subject and the readout direction (x) is oriented along the top-bottom or bottom-top direction of the subject, and wherein the step of weighting at least part of the received magnetic resonance data (48) includes suppressing the voxel data originating from readout locations covering the neck and/or mouth of the subject.

8. The method of any one of the preceding claims,

wherein the weighting step (c) is performed multiple times, each time to reduce the signal originating from different parts of the body region (40, 42), wherein the different parts are expected to have undergone different motion during the acquisition,
and wherein the step of estimating the motion-corrected image dataset includes estimating different motion parameters ($\theta_i$) for the different parts of the body region.

9. The method of claim 8, wherein the different motion parameters ($\theta_i$) for the different parts of the body region (40, 42) are used to produce a combined motion field for the complete body region, using boundary conditions in the transitional zones, herein the combined motion field is used in the estimation of the motion corrected image dataset.

10. The method of claim 8, wherein the step (d) of estimating the motion-corrected image dataset includes estimating motion corrected part-images of the different parts of the body region (40, 42), wherein each part-image is based on different motion parameters, followed by a step of combining the part-images to a complete motion corrected image.

11. The method of any one of the preceding claims, wherein the weighting step (c) is performed on sets of additional k-space lines (30) acquired within a central region (16) of k-space during the magnetic resonance imaging protocol.

12. The method of any one of the preceding claims, wherein the magnetic resonance data has been acquired using a method comprising:

acquiring a low-resolution scout image dataset of the body region, and
acquiring sets of additional k-space lines (30) within a central region (16) of k-space at - at least approximately - regular intervals during the imaging protocol.

13. The method of claim 12, comprising:

weighting the sets of additional k-space lines by reducing the signal depending on a voxel location (48) in readout direction, so as to produce weighted additional k-space lines;
estimating the motion-corrected image dataset by minimizing the data consistency error between the magnetic resonance data (14) acquired in the imaging protocol and the forward model, wherein the estimation includes:

in a first step (54), estimating motion parameters ($\theta_i$) for each set of weighted additional k-space lines (30) by minimizing the data consistency error between the weighted additional k-space lines (30) and the forward model using the low-resolution scout scan as an estimate for the image dataset; and
in a second step (56), estimating the motion-corrected image dataset (x) by minimizing the data consistency error between the magnetic resonance data (14) acquired in the imaging protocol and a forward model described by an encoding matrix, wherein the encoding matrix includes the motion parameters ($\theta_i$) estimated in the first step for each set of weighted additional k-space lines (30), Fourier encoding (F), and optionally subsampling (M) and/or coil sensitivities (C) of a multi-channel coil array (7.1, 7.2).

14. A computer program including program code, which causes a computer to execute the method according to any one of the preceding claims.

15. A magnetic resonance imaging apparatus (1) configured to execute the method of any one of claims 1 to 13, comprising:

a radio frequency controller (7') configured to drive an RF-coil (7) comprising a multi-channel coil array (7.1, 7.2);
a gradient controller (5') configured to control gradient coils (5);
a control unit (13) configured to control the radio frequency controller (7') and the gradient controller (5') to execute the imaging protocol; and
a processing unit (15) configured to execute the method of any one of claims 1 to 13.

# FIG 1

FIG 2

EP 4 679 125 A1

# FIG 3

## FIG 4

$$[\hat{x}] = \text{argmin}_x \, \| E_{\hat{\theta}} x - s \|_2^2$$

$$[\hat{\theta}] = \text{argmin}_\theta \, \| E_\theta \hat{x} - s \|_2^2$$

## FIG 5

52

$$[\hat{\theta}_i] = \text{argmin}_{\theta i} \, \| E_{\theta i} \hat{x} - s_i \|_2^2 \quad \text{— } 54$$

$$[\hat{x}] = \text{argmin}_x \, \| E_{\hat{\theta}} x - s \|_2^2 \quad \text{— } 56$$

## FIG 6

40

42

## FIG 7

## FIG 8

43

X

y

46

44

48

## EUROPEAN SEARCH REPORT

**Application Number**

EP 24 18 8261

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 9 797 974 B2 (UNIV LELAND STANFORD JUNIOR [US]; UNIV CALIFORNIA [US]) 24 October 2017 (2017-10-24) | 1-4,11, 14,15 | INV. G01R33/565 G01R33/48 |
| A | * column 4, line 4 - column 12, line 18; figures 1, 2, 3, 12-14 * ----- | 5-10,12, 13 | G01R33/561 |
| A,D | CAULEY STEPHEN ET AL: "Geometric Coil Mixing (GCM) to Dampen Confounding Signals in MRI Reconstruction", PROCEEDINGS OF THE INTERNATIONAL SOCIETY FOR MAGNETIC RESONANCE IN MEDICINE, 27TH ANNUAL MEETING AND EXHIBITION, MONTREAL, QC, CANADA, 11-16 MAY 2019, vol. 27, 449, 26 April 2019 (2019-04-26), XP040707836, * the whole document * ----- | 4 | |

**TECHNICAL FIELDS SEARCHED (IPC)**

G01R

The present search report has been drawn up for all claims

| Place of search | Date of completion of the search | Examiner |
|---|---|---|
| Munich | 12 December 2024 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 24 18 8261

This annex lists the patent family members relating to the patent documents cited in the above-mentioned European search report.
The members are as contained in the European Patent Office EDP file on
The European Patent Office is in no way liable for these particulars which are merely given for the purpose of information.

12-12-2024

| Patent document cited in search report | Publication date | Patent family member(s) | Publication date |
|---|---|---|---|
| US 9797974 B2 | 24-10-2017 | NONE | |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **J. HAMILTON** ; **D. FRANSON** ; **N. SEIBERLICH**. Recent Advances in Parallel Imaging for MRI. *Prog. Nucl. Magn. Reson. Spectrosc.*, 2017, vol. 101, 71-95

- **L. CORDERO-GRANDE** ; **R. TEIXEIRA** ; **E. HUGHES** ; **J. HUTTER** ; **A. PRICE, HAJNAL**. Sensitivity Encoding for Aligned Multishot Magnetic Resonance Reconstruction. *IEEE Trans. Comput. Imaging*, 2016, vol. 2 (3), 266-280

- **M. W. HASKELL** ; **S. F. CAULEY** ; **L. L. WALD**. TArgeted Motion Estimation and Reduction (TAMER): Data consistency based motion mitigation for MRI using a reduced model joint optimization. *IEEE Trans. Med. Imaging*, 2018, vol. 37 (5), 1253-1265

- **D. POLAK** ; **D. N. SPLITTHOFF** ; **B. CLIFFORD** ; **W.-C. LO** ; **S. HUANG** ; **J. CONKLIN** ; **L. L. WALD** ; **K. SETSOMPOP** ; **S. CAULEY**. Scout accelerated motion estimation and reduction (SAMER). *Magn. Reson. Med.*, 2022, vol. 87, 163-178, https://doi.org/10.1002/mrm.28971

- **D. POLAK** ; **J. HOSSBACH** ; **D. N. SPLITTHOFF et al.** Motion guidance lines for robust data consistency-based retrospective motion correction in 2D and 3D MRI. *Magn. Reson. Med.*, vol. 2023, 1-14

- **D. POLAK et al.** *Magn. Reson. Med.*, vol. 2023, 1-14

- **L. W. S. CAULEY** ; **D. POLAK et al.** Geometric Coil Mixing (GCM) to Dampen Confounding Signals in MRI Reconstruction. *Int. Soc. Magn. Reson. Med. Montr.*, 2019, vol. 0449

- **K. P. PRUESSMANN** ; **M. WEIGER** ; **M. B. SCHEIDEGGER** ; **P. BOESIGER**. SENSE: sensitivity encoding for fast MRI. *Magn. Reson. Med.*, 1999, vol. 42 (5), 952-962

- *Magn. Reson. Med.*, vol. 2023, 1-14